**Europäisches Patentamt**

**European Patent Office**

**Office européen des brevets**

(11) Veröffentlichungsnummer: **0 072 545**
A2

(12) **EUROPÄISCHE PATENTANMELDUNG**

(21) Anmeldenummer: **82107359.0**

(22) Anmeldetag: **13.08.82**

(51) Int. Cl.³: **H 01 L 25/04**
**H 01 L 25/10**

(30) Priorität: **17.08.81 DE 3132337**

(43) Veröffentlichungstag der Anmeldung:
**23.02.83 Patentblatt 83/8**

(84) Benannte Vertragsstaaten:
**AT DE FR GB IT NL SE**

(71) Anmelder: **BROWN, BOVERI & CIE Aktiengesellschaft**
**Kallstadter Strasse 1**
**D-6800 Mannheim 31(DE)**

(72) Erfinder: **Weimann, Klaus, Dipl.-Ing.**
**Wierdenstrasse 19**
**D-6840 Lampertheim(DE)**

(72) Erfinder: **Eisele, Dieter, Dipl.-Phys.**
**Edisonstrasse 10**
**D-6840 Lampertheim(DE)**

(74) Vertreter: **Kempe, Wolfgang, Dr. et al,**
**c/o Brown, Boveri & Cie AG Postfach 351**
**D-6800 Mannheim 1(DE)**

(54) **Halbleitermodul mit mehreren Halbleiterelementen.**

(57) Ein Halbleitermodul, welcher zum Aufbau von Gleichstromstellern für Elektrofahrzeuge verwendet werden soll, enthält eine Montageplatte (10), ein Isoliergehäuse (13) auf der Montageplatte (10), mehrere Halbleiterelemente (T1, D1, D2, D3) im Inneren des Isoliergehäuses (13) und Anschlüsse (1 .... 6') zur Herstellung der elektrischen Verbindungen zwischen den Halbleiterelementen und äußeren Schaltelementen. Die der Montageplatte (10) abgewandte Seite des Isoliergehäuses (13) ist mit einem Kühlkörper (14) verschlossen. Auf der Innenseite des Kühlkörpers (14) sind Hochleistungshalbleiterelemente (T1,D1) lösbar befestigt. Kleinleistungshalbleiterelemente (D2,D3) sind unter Zwischenlage einer isolierenden Keramikplatte (11) auf der Montageplatte (10) befestigt. Montageplatte (10) und Kühlkörper (14) sind mit dem Isoliergehäuse (13) lösbar verbunden.

Fig. 1

1

BROWN,BOVERI & CIE     AKTIENGESELLSCHAFT
Mannheim                           14. Aug. 1981
Mp.-Nr. 614/81                     ZPT/P3-Bi/Bt

## Halbleitermodul

Die Erfindung betrifft einen Halbleitermodul mit einer
Montageplatte, einem Isoliergehäuse auf der Montageplatte,
mehreren Halbleiterelementen im Inneren des Isoliergehäuses
und Anschlüssen zur Herstellung der elektrischen Verbindung
zwischen den Halbleiterelementen und äußeren Schaltelementen.

Derartige Module sind bekannt aus der DE-OS 26 39 979, dem
DE-GM 78 08 801 oder der älteren Anmeldung P 31 27 456.0. Bei
diesen bekannten Modulen sind zwei oder mehr Halbleiterchip
mit Hilfe von Leiterbahnen und Kontaktbrücken untereinander
sowie mit den äußeren Anschlüssen verbunden. Die äußeren
Anschlüsse sind als Schraubkontakte, soweit es sich um die
Hochstromanschlüsse handelt, oder als Steckkontakte, soweit
es sich um die Schwachstromanschlüsse handelt, ausgebildet.
Der Hohlraum im Inneren des Isoliergehäuses ist mit einem
isolierenden Kunststoff ausgegossen, der sämtliche Bauteile
verklebt, fixiert und isoliert.

Will man Gleichstromstellerschaltungen für Elektrofahrzeuge, insbesondere batteriebetriebene Elektroautos, mit Hilfe von derartigen Modulen realisieren, so stellt man fest, daß die handelsüblichen Module hierzu nur wenig geeignet sind. Eine wesentliche, für den vorliegenden Anwendungsfall ungünstige Eigenschaft der bekannten Module besteht darin, daß sämtliche Halbleiter für dieselbe Stromstärke und Spannung dimensioniert sind, was bei Stromstellerschaltungen nicht nötig wäre. Weiterhin muß bei Ausfall eines Halbleiterelements gleich der ganze Modul ausgetauscht und verworfen werden, da eine Reparaturmöglichkeit nicht gegeben ist. Der Aufbau der Gleichstromstellerschaltung nur aus Einzel-Halbleitern würde zwar eine optimale Reparatur ermöglichen, allerdings die Schaltung selbst verteuern und die fabrikmäßige Montage erschweren.

Der vorliegenden Erfindung liegt deshalb die Aufgabe zugrunde, einen Halbleitermodul der eingangs genannten Art anzugeben, der im Falle eines Defektes als ganze Einheit ausgewechselt werden kann, der aber auch die Möglichkeit bietet, defekte Einzelteile einfach auszuwechseln.

Diese Aufgabe wird dadurch gelöst, daß eine Seite des Isoliergehäuses mit einem Kühlkörper verschlossen ist, daß auf der Innenseite des Kühlkörpers Hochleistungshalbleiterelemente befestigt sind, daß auf der Montageplatte Kleinleistungshalbleiterelemente isoliert befestigt sind und daß Montageplatte und Kühlkörper mit dem Isoliergehäuse lösbar verbunden sind.

Dabei ergeben sich die Vorteile, daß vier unterschiedliche Auswechselmöglichkeiten bestehen. Entweder wird der Modul komplett ausgetauscht oder nur die Montageplatte mit den darauf befestigten Kleinleistungshalbleiterelementen oder der Kühlkörper mit allen Hochleistungshalbleiterelementen oder nur eines der Hochleistungshalbleiterelemente allein. Ferner kann der Modul an jeder beliebigen Stelle, z.B. auch am Lagerschild des das Fahrzeug antreibenden Elektromotors befestigt werden, da die Montageplatte potentialfrei ist.

Vorteilhafterweise sind die einzelnen Anschlüsse am Isoliergehäuse als Schraub- oder Steckkontakte ausgebildet. Die Vorteile der verschiedenen Kontaktarten sind bekannt.

Vorzugsweise besitzen die Hochleistungshalbleiterelemente eigene Gehäuse respektive Montageplatten und sind mit dem Kühlkörper druckkontaktiert oder verschraubt. Dadurch ergibt sich eine optimale Abführung der in den Hochleistungshalbleiterelementen entstehenden Wärme, eine günstige elektrische Kontaktierung der Hochleistungshalbleiterelemente untereinander sowie gleichzeitig eine leichte Austauschbarkeit der Einzelteile.

Gemäß einer vorteilhaften Ausbildung ist der Anschluß für die Steuerelektrode des bzw. der steuerbaren Halbleiterelemente(s) mit einem Hilfskathodenanschluß als Doppelsteckkontakt ausgebildet. Der Aufbau sowie die Vorteile eines derartigen Doppelsteckkontaktes sind aus dem eingangs erwähnten DE-GM 78 08 801 bekannt.

Wie schon eingangs erwähnt, findet der erfindungsgemäße Modul seine besonders vorteilhafte Anwendung beim Aufbau eines Gleichstromstellers für Elektrofahrzeuge, insbesondere batteriebetriebene Elektroautos.

Weitere Merkmale und Vorteile der Erfindung ergeben sich aus der noch folgenden Beschreibung eines Ausführugnsbeispiels anhand der Zeichnung.

Es zeigen:

Fig. 1    einen Querschnitt durch einen schematisiert dargestellten Modul,

Fig. 2    das elektrische Schaltbild zu dem Modul der Fig. 1
          und

Fig. 3    das elektrische Schaltbild eines anderen, handelsüblichen Moduls.

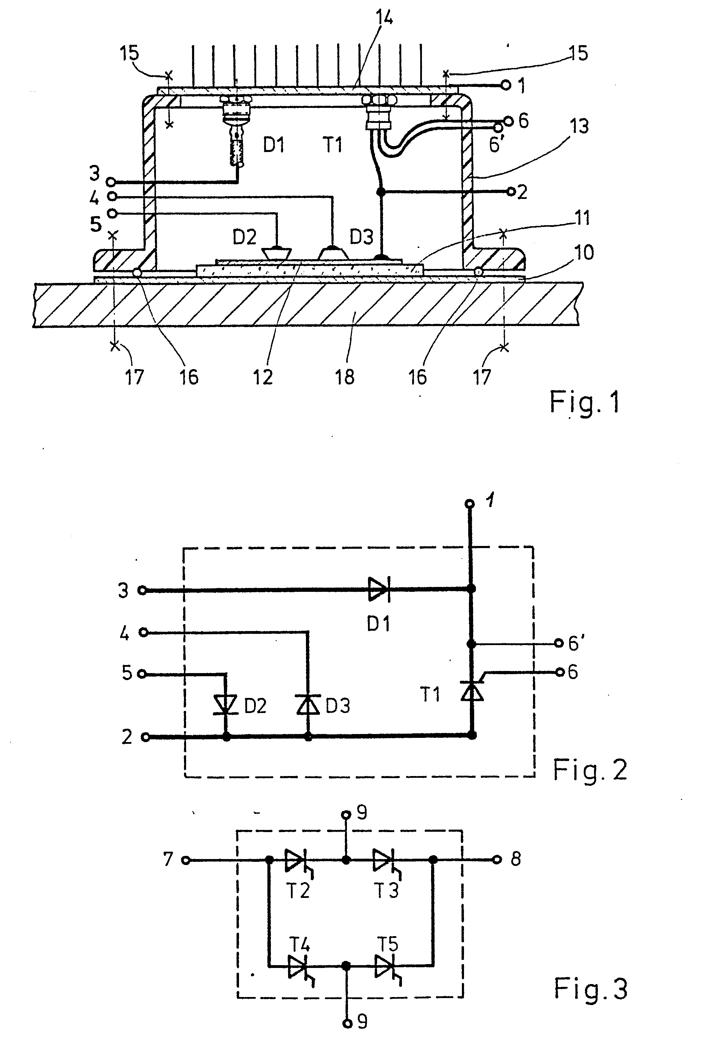

In Fig. 1 erkennt man eine Montageplatte 10 aus Metall, auf der eine Keramikplatte 11 befestigt ist, auf deren Oberseite sich wiederum Leiterbahnen 12 und zwei Dioden D2, D3 in Form von direkt aufgelöteten Halbleiterchip befinden. Auf der Montageplatte 10 ist ferner unter Zwischenlage eines Dichtrings 16 ein Isoliergehäuse 13 befestigt. Die Deckseite des Isoliergehäuses 13 ist durch einen Kühlkörper 14 verschlossen, der auf seiner Außenseite Kühlrippen für die verbesserte Wärmeabgabe an die Umgebung besitzt. Der Kühlkörper 14 ist über Befestigungselemente 15, z.B. Schrauben oder Nieten, mit dem Isoliergehäuse 13 verbunden. Auf der Innenseite des Kühlkörpers 14 sind zwei Hochleistungshalbleiterelemente, und zwar eine Diode D1 und ein Thyristor T1 befestigt. Beide Elemente D1, T1 besitzen je ein eigenes Gehäuse bzw. eine eigene Montageplatte, so daß sie im Reparaturfall einzeln ausgetauscht werden können. Sämtliche Halbleiterelemente im Inneren des Moduls sind - soweit schaltungstechnisch nötig - untereinander sowie mit externen Anschlüssen 1....6' verbunden. Der fertige Modul ist mit Hilfe von Verbindungslementen 17, z.B. wieder Schrauben, auf einer Metallplatte 18 befestigt. Diese Metallplatte 18 kann beispielsweise das Lagerschild eines Elektromotors sein.

Wie man anhand der Fig. 1 leicht erkennen kann, kann im Reparaturfall entweder der ganze Modul ausgetauscht werden oder nur die Montageplatte 10 mit den Dioden D2, D3 oder der Kühlkörper 14 mit den Halbleiterelementen D1, T1 oder auch nur eines der Halbleiterelemente D1, T1. Dadurch besteht die Möglichkeit, in der Autoreparaturwerkstatt zwar den ganzen Modul auszutauschen, um die Verweildauer des zu reparierenden Fahrzeugs in der Werkstatt minimal zu halten, den Modul selbst aber anschließend durch Austausch nur des defekten Halbleiterelements wieder zu reparieren und neu zu verwenden.

Fig. 2 zeigt das Schaltbild zu dem Modul der Fig. 1. Man erkennt die beiden Hochleistungshalbleiterelemente T1, D1, deren Kathoden zusammengeschaltet und an den äußeren Anschluß 1 geführt sind. Die Anode des Thyristors T1 ist an den Anschluß 2 geführt; mit dem Anschluß 2 sind die Kathode der Diode D2 und die Anode der Diode D3 verbunden, deren zweite Elektroden mit den äußeren Anschlüssen 4 bzw. 5 verbunden sind. Die Anode der Diode D1 ist mit dem Anschluß 3 verbunden. Die Steuerelektrode des Thyristors T1 ist an den Anschluß 6 geführt, der mit einem Hilfskathodenanschluß 6' als vorteilhafter Doppelstecker zum Zuführen der Thyristorzündimpulse ausgebildet werden kann.

Fig. 3 zeigt das Schaltbild eines handelsüblichen Halbleitermoduls, der als Vollwellenbrückenschaltung mit vier Thyristoren T2, T3, T4, T5 mit untereinander gleichen elektrischen Parametern ausgebildet ist. Mit je einem Modul nach Fig. 2 und Fig. 3 kann eine Gleichstromstellerschaltung für den Ankerstrom eines Gleichstromfahrmotors aufgebaut werden. Hierzu wird Anschluß 7 mit Anschluß 2 verbunden, zwischen die Anschlüsse 9 wird ein Kommutierungskondensator geschaltet,

Anschluß 8 wird mit der Kommutierungsdrossel, Anschluß 2 wird mit der Batterie und Anschluß 1 mit dem Anker des Fahrmotors verbunden. Dabei wirkt der Thyristor T1 als Stellerthyristor und die Diode D1 als Umschwingdiode für den Kommutierungskreis. Derartiger Gleichstromstellerschaltungen sind bekannt.

A n s p r ü c h e

1. Halbleitermodul mit einer Montageplatte (10, einem Isoliergehäuse (13) auf der Montageplatte (10), mehreren Halbleiterelementen (T1, D1, D2, D3) im Inneren des Isoliergehäuses (13) und Anschlüssen (1....6') zur Herstellung der elektrischen Verbindung zwischen den Halbleiterelementen (T1, D1...D3) und äußeren Schaltelementen, dadurch gekennzeichnet, daß eine Seite des Isoliergehäuses (13) mit einem Kühlkörper (14) verschlossen ist, daß auf der Innenseite des Kühlkörpers (14) Hochleistungshalbleiterelemente (T1,D1) befestigt sind, daß auf der Montageplatte (10) Kleinleistungshalbleiterelemente (D2,D3) isoliert befestigt sind und daß Montageplatte (10) und Kühlkörper (14) mit dem Isoliergehäuse (13) lösbar verbunden sind.

2. Halbleitermodul nach Anspruch 1, dadurch gekennzeichnet, daß die äußeren Anschlüssen (1....6') am Isoliergehäuse (13) als Schraub- und/oder Steckkontakte ausgebildet sind.

3. Halbleitermodul nach Anspruch 1, dadurch gekennzeichnet, daß die Hochleistungshalbleiterelemente (T1,D1) eigene Gehäuse oder Montageplatten besitzen.

4. Halbleitermodul nach Anspruch 3, dadurch gekennzeichnet, daß die Hochleistungshalbleiterelemente (T1,D1) mit dem Kühlkörper (14) druckkontaktiert oder verschraubt sind.

5. Halbleitermodul nach wenigstens einem der Ansprüche 1 bis 4, dadurch gekennzeichnet, daß der Anschluß (6) für die Steuerelektrode des (der) steuerbaren Halbleiterelemente (T1) mit einem Hilfskathodenanschluß (6') als Doppelsteckkontakt ausgebildet ist.

6. Halbleitermodul nach den Ansprüchen 1 bis 5, gekennzeichnet durch seine Anwendung zum Aufbau eines Gleichstromstellers für Elektrofahrzeuge.

Fig. 1

Fig. 2

Fig. 3